# EUROPEAN PATENT SPECIFICATION

(11) **EP 3 794 728 B1**
(45) Date of publication and mention of the grant of the patent: **01.07.2026**
(21) Application number: 18918533.3
(22) Date of filing: 07.08.2018
(51) Int. Cl.: H03K 3/84

(54) **RANDOM NUMBER GENERATOR**
ZUFALLSZAHLENGENERATOR
GÉNÉRATEUR DE NOMBRES ALÉATOIRES

(30) Priority: 17.05.2018 PL 42558518; 17.05.2018 PL 42558618
(43) Date of publication of application: 24.03.2021
(60) Divisional application: 24208861.5
(73) Proprietor: POLITECHNIKA WARSZAWSKA, 00-661 Warszawa (PL)
(72) Inventor: GOLOFIT, Krzysztof, 02-798 Warszawa (PL); WIECZOREK, Piotr, 04-994 Warszawa (PL)
(74) Representative: Wroblewski, Marcin Jan
(86) International application number: PCT/IB2018/055940
(87) International publication number: WO 2019/220193

(56) References cited:
- WO-A1-01/61854
- WO-A1-2017/146650
- US-A- 5 153 532
- US-A1- 2009 077 147
- US-A1- 2011 169 580
- US-A1- 2014 250 160
- WIECZOREK PIOTR ZBIGNIEW ET AL: "True Random Number Generator Based on Flip-Flop Resolve Time Instability Boosted by Random Chaotic Source", IEEE TRANSACTIONS ON CIRCUITS AND SYSTEMS I: REGULAR PAPERS, IEEE, US, vol. 65, no. 4, 1 April 2018 (2018-04-01), pages 1279 - 1292, XP011678918, ISSN: 1549-8328, [retrieved on 20180309], DOI: 10.1109/TCSI.2017.2751144
- WIECZOREK PIOTR Z ED - HEMMATI HAMID *1954-* [HERAUSGEBERIN] IDENTITY ET AL: "Secure TRNG with random phase stimulation", PROCEEDINGS OF SPIE; [PROCEEDINGS OF SPIE ISSN 0277-786X VOLUME 10524], SPIE, US, vol. 10445, 7 August 2017 (2017-08-07), pages 104452A - 104452A, XP060091482, ISBN: 978-1-5106-1533-5, DOI: 10.1117/12.2280979

## Description

### Technical Field

The invention concerns a random number generator intended especially for generating truly random numbers and series.

### Background

There are known in the art designs of random number generators, which use pairs of ring oscillators and bistables, such as a phase detector or a metastability circuit.

In the state of the art, from the article by Piotr Z. Wieczorek, "Secure TRNG with Random Phase Stimulation", XL-th IEEE-SPIE Joint Symposium on Photonics, Web Engineering, Electronics for Astronomy and High Energy Physics Experiments, Wilga 2017, SPIE volume 10445, ISBN: 9781510613546, Electronic ISBN: 9781510613553, there is known a random number generator, which comprises two ring oscillators and a metastability circuit. Outputs of the ring oscillators are connected to inputs of the metastability circuit, whereas an output of the metastability circuit is an output of the random number generator. A ring oscillator comprise a delay line closed in a loop, where an input and an output are connected with each other and connected to an output of the ring oscillator. The delay line comprise delays connected in series and connected between the input and the output of the delay line. The disadvantage of such a random number generator is its low speed resulting from rare occurrences of events that are able to initiate a metastable work of the metastability circuit, which results from slow-moving random walk in phase.

From the publication of the US patent application US2011169580, there is known in the art a random number generator comprising two ring oscillators a phase detector. Outputs of two ring oscillators are connected to inputs of the phase detector, whereas an output of the phase detector is connected to an output of the random number generator through a von Neumann corrector. A ring oscillator comprise a delay line closed in a loop, where an input and an output are connected with each other and connected to an output of the ring oscillator. The delay line comprise delays connected in series and connected between the input and the output of the delay line.

From the article by Piotr Z. Wieczorek and Krzysztof Golofit, "True Random Number Generator Based on Flip-Flop Resolve Time Instability Boosted by Random Chaotic Source", IEEE Transactions on Circuits and Systems--I: Regular Papers, Volume: 65, Issue: 4, pp. 1279-1292, April 2018 (published: 26 September 2017), DOI: 10.1109/TCSI.2017.2751144, there is known a true random number generator (TRNG) based on two stages of randomness. One based on a chaotic circuit and the second one on a metastability. The true random number generator (TRNG) comprises a first bistable (PhDet) having an output connected to a first output of the random number generator and comprising two ring oscillators (SCOR1, SCOR2) having outputs connected inputs of the bistable (PhDet). Further, the ring oscillators (SCOR1, SCOR2) comprise delay lines, e.g. inverters, closed in a loops. Said inverters being the delay lines comprise delays connected in series between inputs and outputs of the delay lines. The true random number generator (TRNG) comprises an additional bistable (RS latch) with output connected to an additional output of the true random number generator (TRNG). The additional bistable (RS latch) has a first input connected to the delay line of one of the ring oscillators (SCOR1) and a second input connected to the delay line of the other of the ring oscillators (SCOR2).

From the publication of the PCT application WO2017146650A1, there is known a true random number generator comprising three ring oscillators, each having different frequency and a capacitor connected between the second ring oscillator and the third ring oscillator to provide a capacitive coupling therebetween. The true random number generator further comprises a first D-type flip-flop having a data input connected to an output of the first ring oscillator and having a clock input connected to an output of the third ring oscillator, wherein the D-type flip-flop is configured to generate an output signal representing a sequence of random numbers. The true random generator has also a second D-type flip-flop configured to generate a respective second output signal representing a respective second sequence of random numbers.

Further, the publication of the US application US20140250160A1 discloses a random number generator comprising a first oscillator, a second oscillator, a sampling unit and a third oscillator and control unit. The first oscillator configured to output a first oscillating signal having a first frequency. The second oscillator is configured to output a second oscillating signal having a second frequency different from the first frequency. The sampling unit is configured to receive the first and second oscillating signals and to generate at least one entropy source by combining the received first and second oscillating signals. Further, the sampling unit is configured to generate a random bit corresponding to the generated entropy source using a third oscillating signal. The third oscillator and the control unit is configured to control the first and second oscillators and to generate the third oscillating signal. A frequency of the third oscillating signal is lower than the first and second frequencies.

The aim of the invention is to provide a random number generator whereby a phase detector thereof provides a precise detection of the edge priority of input waveforms, which is used for phase correction.

### Summary

The invention relates to a random number generator according to claim 1 with further embodiments according to the dependent claims. A random number generator comprising a plurality of bistables, wherein a first bistable of said plurality of bistables, has an output connected to a first output of the random number generator, and comprising two ring oscillators having outputs connected to inputs of the first bistable, wherein the ring oscillators comprise delay lines closed in loops, and the delay lines comprise delays connected in series between inputs and outputs of the delay lines, wherein the random number generator comprises at least one second bistable of said plurality of bistables, each having an output connected to a respective additional output of the random number generator, wherein each second bistable has a first input connected to the delay line of one of the two ring oscillators and a second input connected to the delay line of the other of the two ring oscillators, wherein at least one of said plurality of bistables is a phase detector, wherein at least one phase detector comprises a first and a second flip-flop, each having two inputs and two outputs, wherein one of the two outputs is a normal output and the other is a complementary output; wherein the inputs of the flip-flops are connected to inputs of the phase detector, and wherein the first input of the phase detector is connected to both the first input of the first flip-flop and the second input of the second flip-flop, the second input of the phase detector is connected to both the second input of the first flip-flop and the first input of the second flip-flop, the output of the phase detector is connected to the complementary output of the first flip-flop and the normal output of the second flip-flop through a logic circuit. At least one of said plurality of the bistables, which is not one of the at least one phase detector, is a metastability circuit comprises a metastable circuit with an oscillatory response, the metastable circuit having two inputs being the inputs of the metastability circuit and having an output, the output of the metastable circuit is connected to the output of the metastability circuit through an adder, the metastability circuit comprises further a counter, having outputs connected to consecutive inputs of the adder, and having an input connected to the output of the metastable circuit.
Such a solution provides a random response of the circuit in the case of proximity of the edges of the input waveforms. More specifically, for phase shifts that do not fit in the metastability window, the metastability circuit provides a phase detection and is used to correct the phase of the ring oscillators connected to its inputs. However, for phase shifts located in the metastability window, the metastability circuit provides a random value on its output and consequently induces a random phase change, which differs the this circuit from the phase detector.

Random number generator according to the invention advantageously comprises at least three ring oscillators. Further, the at least one second bistable has the first input connected to the delay line of one of the ring oscillators and the second input connected to the delay line of the second or the third of the ring oscillators. The effect is that the bistables connected to different ring oscillators are stimulated with less correlated signals than the bistables connected to the same ring oscillators.

Random number generator according to the invention advantageously comprises at least two second bistables, having at least one of the inputs connected to different delay lines of different ones of said three ring oscillators. Such a solution assures that the bistables are stimulated with different pair of ring oscillators, and thus with different processes resulting in phase shifts.

Advantageously at least one of the second bistables is connected with the first input to a series of delays of the respective delay line of one of the ring oscillators after a delay having the first number in this series counting from the beginning of the delay line. Further the second input is connected to a series of delays of the respective delay line of another ring oscillator after a delay having the second number in this series counting from the beginning of the delay line. Further the first number is different from the second number. Such a solution causes that the bistable is triggered by the input signal with a different phase than the phase that is currently present in the ring oscillators.

At least two bistables advantageously are connected with at least one input each in the same place of at least one delay line. Having different bistables connected in the same places causes that the bistables are triggered with exactly the same signal.

### Brief description of the drawings

The invention has been described below in detail, with reference to the attached figures. Fig.1 presents a block diagram of random number generator with two ring oscillators, fig.2 presents a block diagram of random number generator with three ring oscillators, fig.3 presents a block diagram of phase detector comprising two flip-flops, fig.4 presents a block diagram of metastability circuit comprising metastable circuit with an oscillatory response, adder and counter.

### Detailed description

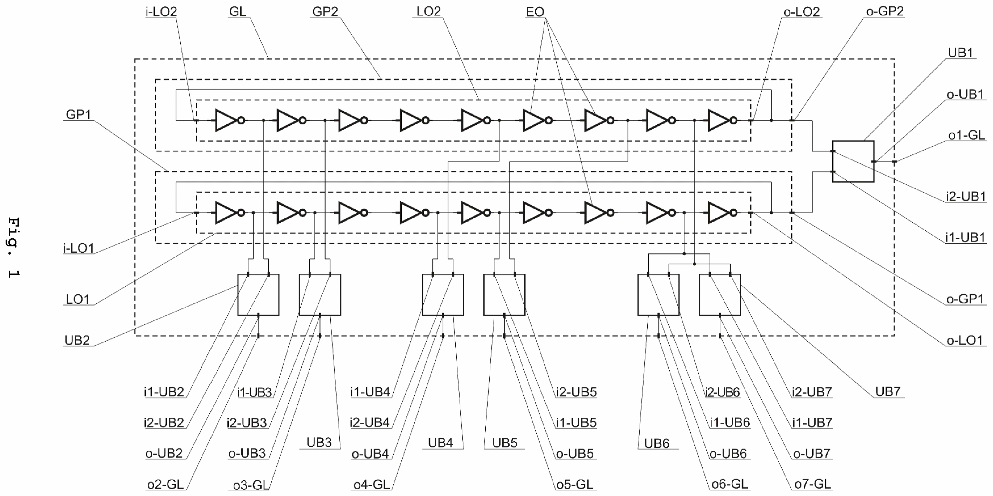

Random number generator presented in fig.1 comprises two ring oscillators GP1 and GP2 and seven bistables UB1, UB2, UB3, UB4, UB5, UB6 and UB7. The ring oscillators GP1 and GP2 comprise delay lines LO1 and LO2 closed in loops so, that an output o-LO1 and o-LO2 of a delay line LO1 and LO2 is connected to an input i-LO1 and i-L02 of this delay line and also the outputs of the delay lines LO1 and LO2 are connected to outputs of the ring oscillators GP1 and GP2. The delay lines LO1 and LO2 comprise delays EO connected in series between the inputs i-LO1 and i-LO2 and the outputs o-LO1 and o-LO2 of these delay lines. Outputs o-UB1, o-UB2, o-UB3, o-UB4, o-UB5, o-UB6 and o-UB7 of the bistables UB1, UB2, UB3, UB4, UB5, UB6 and UB7 are connected to outputs o1-GL, o2-GL, o3-GL, o4-GL, o5-GL, o6-GL and o7-GL of the random number generator GL. First input i1-UB1 of the first bistable UB1 is connected to the delay line LO1 of the first ring oscillator GP1 to an output of the last delay EO counting from the beginning of this delay line. Second input i2-UB1 of the first bistable UB1 is connected to the delay line LO2 of the second ring oscillator GP2 to an output of the last delay EO counting from the beginning of this delay line. First input i1-UB2 of the second bistable UB2 is connected to the delay line LO1 of the first ring oscillator GP1 to an output of the first delay EO counting from the beginning of this delay line. Second input i2-UB2 of the second bistable UB2 is connected to the delay line LO2 of the second ring oscillator GP2 to an output of the first delay EO counting from the beginning of this delay line. First input i1-UB3 of the third bistable UB3 is connected to the delay line LO1 of the first ring oscillator GP1 to an output of the second delay EO counting from the beginning of this delay line. Second input i2-UB3 of the third bistable UB3 is connected to the delay line LO2 of the second ring oscillator GP2 to an output of the second delay EO counting from the beginning of this delay line. First input i1-UB4 of the fourth bistable UB4 is connected to the delay line LO1 of the first ring oscillator GP1 to an output of the fourth delay EO counting from the beginning of this delay line. Second input i2-UB4 of the fourth bistable UB4 is connected to the delay line LO2 of the second ring oscillator GP2 to an output of the fifth delay EO counting from the beginning of this delay line. First input i1-UB5 of the fifth bistable UB5 is connected to the delay line LO1 of the first ring oscillator GP1 to an output of the fifth delay EO counting from the beginning of this delay line. Second input i2-UB5 of the fifth bistable UB5 is connected to the delay line LO2 of the second ring oscillator GP2 to an output of the seventh delay EO counting from the beginning of this delay line. First input i1-UB6 of the sixth bistable UB6 is connected to the delay line LO1 of the first ring oscillator GP1 to an output of the eighth delay EO counting from the beginning of this delay line. Second input i2-UB6 of the sixth bistable UB6 is connected to the delay line LO2 of the second ring oscillator GP2 to an output of the eighth delay EO counting from the beginning of this delay line. First input i1-UB7 of the seventh bistable UB7 is connected to the delay line LO1 of the first ring oscillator GP1 to an output of the eighth delay EO counting from the beginning of this delay line. Second input i2-UB7 of the seventh bistable UB7 is connected to the delay line LO2 of the second ring oscillator GP2 to an output of the eighth delay EO counting from the beginning of this delay line.

The first three of the bistables UB1, UB2 and UB3 are connected to delay lines in the way that assures the delays EO are driven by bistables in the minimal manner and at the same time the bistables are stimulated by similar signals - that is, similar phase shifts of the signals of the ring oscillators GP1 and GP2. The third, the fourth and the fifth of the bistables UB3, UB4 and UB5 are also connected to delay lines in the way that assures the delays EO are driven by bistables in the minimal manner, however each of these bistables is stimulated by completely different phase shift of signals of the ring oscillators GP1 and GP2. The sixth bistable UM6 is stimulated by the same signals as the seventh bistable UM7. The identical structure of these two bistables UM6 and UM7 provides similar conditions for their stimulation, whereas their different structure - in particular symmetrical with respect to one another, but with asymmetrical operating characteristics - ensures the stimulation of these circuits at different phase shifts.

The number of delays and the delay caused by each delay EO determine the basic operating frequencies of the ring oscillators GP1 and GP2. The basic frequency has a random component, resulting from physical phenomena - typical for electronic circuits (noise, thermal phenomena, jitter, etc.) - and because of that the signal phase also manifests random changes.

The positive or negative phase offset of the input signals of a bistable being a phase detector provides random values at the output of the phase detector. The proximity of the oscillators' phases means time closeness of the edges of generated signals, which are used to stimulate bistables being metastability circuits, which produce random phenomena. The exceptions are the bistables connected to the delay lines with particular shifts, because the goal is to achieve a different phase stimulation - shifted by one or multiple propagation times of a delay EO.

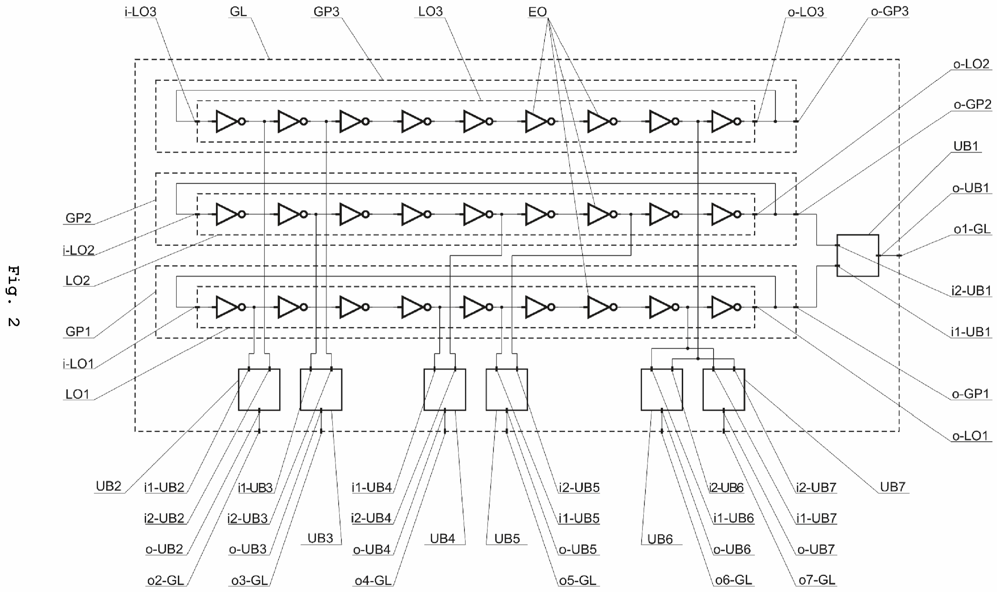

Random number generator presented in fig.2 comprises three ring oscillators GP1, GP2 and GP3 and seven bistables UB1, UB2, UB3, UB4, UB5, UB6 and UB7. The ring oscillators GP1, GP2 and GP3 comprise delay lines LO1, LO2 and LO3 closed in loops so, that an output o-LO1, o-LO2 and o-LO3 of a delay line LO1, LO2 and LO3 is connected to an input i-LO1, i-LO2 and i-LO3 of this delay line and also the outputs of the delay lines o-LO1, o-LO2 and o-LO3 are connected to outputs of the ring oscillators o-GP1, o-GP2 and o-GP3. The delay lines LO1, LO2 and LO3 comprise delays EO connected in series between the inputs i-LO1, i-L02 and i-LO3 and the outputs o-LO1, o-LO2 and o-LO3 of these delay lines. Outputs o-UB1, o-UB2, o-UB3, o-UB4, o-UB5,o-UB6 and o-UB7 of the bistables UB1, UB2, UB3, UB4, UB5, UB6 and UB7 are connected to outputs o1-GL, o2-GL, o3-GL, o4-GL, o5-GL, o6-GL and o7-GL of the random number generator GL. First input i1-UB1 of the first bistable UB1 is connected to the delay line LO1 of the first ring oscillator GP1 to an output of the last delay EO counting from the beginning of this delay line. Second input i2-UB1 of the first bistable UB1 is connected to the delay line LO2 of the second ring oscillator GP2 to an output of the last delay EO counting from the beginning of this delay line. First input i1-UB2 of the second bistable UB2 is connected to the delay line LO1 of the first ring oscillator GP1 to an output of the first delay EO counting from the beginning of this delay line. Second input i2-UB2 of the second bistable UB2 is connected to the delay line LO3 of the third ring oscillator GP3 to an output of the first delay EO counting from the beginning of this delay line. First input i1-UB3 of the third bistable UB3 is connected to the delay line LO2 of the second ring oscillator GP2 to an output of the second delay EO counting from the beginning of this delay line. Second input i2-UB3 of the third bistable UB3 is connected to the delay line LO3 of the third ring oscillator GP3 to an output of the second delay EO counting from the beginning of this delay line. First input i1-UB4 of the fourth bistable UB4 is connected to the delay line LO1 of the first ring oscillator GP1 to an output of the fourth delay EO counting from the beginning of this delay line. Second input i2-UB4 of the fourth bistable UB4 is connected to the delay line LO2 of the second ring oscillator GP2 to an output of the fifth delay EO counting from the beginning of this delay line. First input i1-UB5 of the fifth bistable UB5 is connected to the delay line LO1 of the first ring oscillator GP1 to an output of the fifth delay EO counting from the beginning of this delay line. Second input i2-UB5 of the fifth bistable UB5 is connected to the delay line LO2 of the second ring oscillator GP2 to an output of the seventh delay EO counting from the beginning of this delay line. First input i1-UB6 of the sixth bistable UB6 is connected to the delay line LO1 of the first ring oscillator GP1 to an output of the eighth delay EO counting from the beginning of this delay line. Second input i2-UB6 of the sixth bistable UB6 is connected to the delay line LO3 of the third ring oscillator GP3 to an output of the eighth delay EO counting from the beginning of this delay line. First input i1-UB7 of the seventh bistable UB7 is connected to the delay line LO1 of the first ring oscillator GP1 to an output of the eighth delay EO counting from the beginning of this delay line. Second input i2-UB7 of the seventh bistable UB7 is connected to the delay line LO3 of the third ring oscillator GP3 to an output of the eighth delay EO counting from the beginning of this delay line.

The first three of the bistables UB1, UB2 and UB3 are connected to delay lines in the way that assures the delays EO are driven by bistables in the minimal manner and at the same time the bistables are stimulated by similar signals - that is, similar phase shifts of the signals of the ring oscillators GP1 and GP2, GP1 and GP3, GP2 and GP3. In result the stimulations of bistables connected to different ring oscillators are uncorrelated or slightly correlated, which improves the randomness of numbers on the outputs of these circuits. The first, the fourth and the fifth of the bistables UB1, UB4 and UB5 are also connected to delay lines in the way that assures the delays EO are driven by bistables in the minimal manner, however each of these bistables is stimulated by completely different phase shift of signals of the ring oscillators GP1 and GP2. The sixth bistable UM6 is stimulated by the same signals as the seventh bistable UM7. The identical structure of these two bistables UM6 and UM7 provides similar conditions for their stimulation, whereas their different structure - in particular symmetrical with respect to one another, but with asymmetrical operating characteristics - ensures the stimulation of these circuits at different phase shifts.

Depending on whether the rising edge on the D input of the flip-flop occurs before or after the rising edge on the C input of the flip-flop, the logic '1' or logic '0' will appear on the output Q.

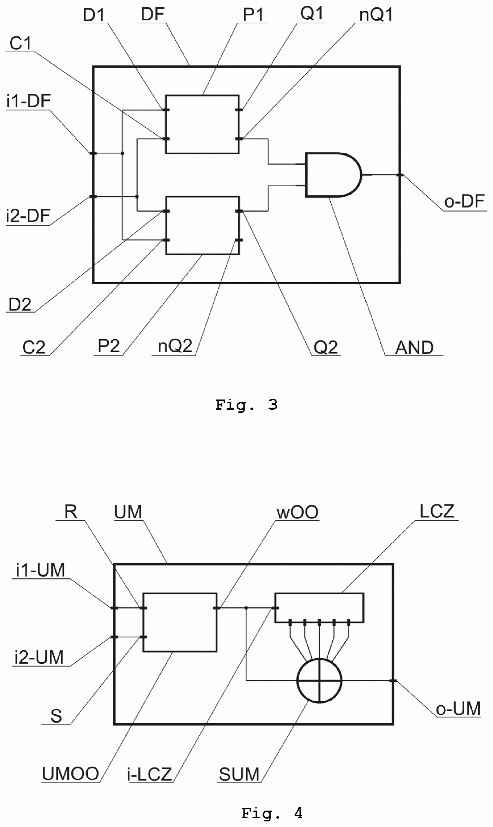

Phase detector presented in fig.3 comprises a logic circuit AND having two inputs and one output as well as two flip-flops P1 and P2, having two inputs D1, C1 and D2, C2 each as well as two outputs Q1, nQ1 and Q2, nQ2 each. One of the two outputs Q1, nQ1 and Q2, nQ2 is a normal output Q1, Q2 and the other is a complementary output nQ1, nQ2. The inputs D1, C1 and D2, C2 of the flip-flops P1, P2 are connected to inputs i1-DF, i2-DF of the phase detector DF, whereas the outputs Q1, nQ1 and Q2, nQ2 of the flip-flops P1, P2 are connected to an output of the phase detector DF through the logic circuit AND. The first input of the phase detector i1-DF is connected to both the first input D1 of the first flip-flop P1 and the second input C2 of the second flip-flop P2. The second input of the phase detector i2-DF is connected to both the second input C1 of the first flip-flop P1 and the first input D2 of the second flip-flop P2. The inputs of the logic circuit AND are connected to the complementary output of the first flip-flop nQ1 and the normal output of the second flip-flop Q2. The output of the logic circuit AND is connected to the output of the phase detector o-DF.

The phase detector composed of two flip-flops provides symmetrical detection of negative and positive phase shifts.

Metastability circuit presented in fig.4 comprises a metastable circuit with an oscillatory response UMOO having two inputs R and S being the inputs i1-UM and i2-UM of the metastability circuit UM, and an output wOO

The metastable circuit UMOO is characterized by the fact that the proximity of the edges of signals on the inputs of the flip-flop R and S causes a metastable range of operation resulting in oscillatory response of the flip-flop with a variable number of oscillations as well as in a random response at the output wOO.

The output wOO of the metastable circuit UMOO is connected to the output o-UM of the metastability circuit UM through an adder SUM.

The adder SUM is used for adding up a variable number of oscillations at the output wOO.

Metastability circuit UM presented in fig.4 additionally comprises a counter LCZ, having outputs connected to consecutive inputs of the adder SUM and having an input i-LCZ connected to the output wOO of the metastable circuit UMMO.

The counter LCZ is used for counting a variable number of oscillations at the output wOO, which then adds the adder SUM. Moreover, the logical state at the output wOO is also taken into account in this circuit.

The invention can be applied and used in generating truly random numbers and series.

## Claims

1. A random number generator (GL) comprising a plurality of bistables (UB1, UB2, UB3, UB4, UB5, UB6, UB7), wherein a first bistable (UB1) of said plurality of bistables has an output (o-UB1) connected to a first output (o1-GL) of the random number generator (GL), and comprising two ring oscillators (GP1, GP2) having outputs (o-GP1, o-GP2) connected to inputs (i1-UB1, i2-UB1) of the first bistable (UB1), wherein the ring oscillators comprise delay lines (LO1, LO2) closed in loops, and the delay lines (LO1, LO2) comprise delays (EO) connected in series between inputs (iLO1, i-LO2) and outputs (o-LO1, o-LO2) of the delay lines (LO1, LO2), wherein the random number generator (GL) comprises at least one second bistable (UB2, UB3, UB4, UB5, UB6, UB7) of said plurality of bistables, each having an output (o-UB2, o-UB3, o-UB4, o-UB5, o-UB6, o-UB7) connected to a respective additional output (o2-GL, o3-GL, o4-GL, o-5GL, o6-GL, o7-GL) of the random number generator (GL), wherein each second bistable (UB2, UB3, UB4, UB5, UB6, UB7) has a first input (i1-UB2, i1-UB3, i1-UB4, i1-UBS, i1-UB6, i1-UB7) connected to the delay line (LO1) of one of the two ring oscillators (GP1) and a second input (i2-UB2, i2-UB3, i2-UB4, i2-UBS, i2-UB6, i2-UB7) connected to the delay line (LO2) of the other of the two ring oscillators (GP2), **characterised in that** at least one of said plurality bistables (UB1, UB2, UB3, UB4, UB5, UB6, UB7) is a phase detector (DF), wherein at least one phase detector (DF) comprises a first and a second flip-flop (P1), (P2), each having two inputs (D1, C1), (D2, C2) and two outputs (Q1, nQ1), (Q2, nQ2), wherein one of the two outputs (Q1, nQ1), (Q2, nQ2) is a normal output (Q1, Q2) and the other is a complementary output (nQ1, nQ2);
wherein:
- the inputs (D1, C1), (D2, C2) of the flip-flops (P1), (P2) are connected to inputs (i1-DF, i2-DF) of the phase detector(DF), and wherein
- the first input of the phase detector (i1-DF) is connected to both the first input (D1) of the first flip-flop (P1) and the second input (C2) of the second flip-flop (P2),
- the second input of the phase detector (i2-DF) is connected to both the second input (C1) of the first flip-flop (P1) and the first input (D2) of the second flip-flop (P2),
- the output of the phase detector (o-DF) is connected to the complementary output (nQ1) of the first flip-flop (P1) and the normal output (Q2) of the second flip-flop (P2) through a logic circuit (AND),
- at least one of said plurality of the bistables (UB1, UB2, UB3, UB4, UB5, UB6, UB7), which is not one of the at least one phase detector, is a metastability circuit (UM) that comprises a metastable circuit with an oscillatory response (UMOO), the metastable circuit (UMOO) having two inputs (R, S) being the inputs of the metastability circuit (i1-UM, i2-UM) and having an output (wOO),
- the output (wOO) of the metastable circuit (UMOO) is connected to the output (o-UM) of the metastability circuit (UM) through an adder (SUM),
- the metastability circuit (UM) comprises further a counter (LCZ), having outputs connected to consecutive inputs of the adder (SUM), and having an input (i-LCZ) connected to the output (wOO) of the metastable circuit (UMMO).

2. The random number generator according to claim 1, **characterized in that** it comprises at least three ring oscillators (GP1, GP2, GP3), and **in that** the at least one second bistable (UB2, UB3, UB4, UB5, UB6, UB7) has the first input (i1-UB2, i1-UB3, i1-UB4, i1-UB5, i1-UB6, i1-UB7) connected to the delay line (LO1, LO2) of one of the ring oscillators (GP1, GP2) and the second input (i2-UB2, i2-UB3, i2-UB4, i2-UB5, i2-UB6, i2-UB7) connected to the delay line (LO2, LO3) of the second or the third of the ring oscillators (GP2, GP3).

3. The random number generator according to claim 2, **characterized in that** it comprises at least two second bistables (UB1, UB2, UB3), having at least one of the inputs (i1-UB2, i1-UB3; i2-UB1, i2-UB2; i1-UB1, i2-UB3) connected to different delay lines (LO1, LO2, LO3) of different ones of said three ring oscillators (GP1, GP2, GP3).

4. The random number generator according to claim 1 or 2 or 3, **characterized in that** at least one of the second bistables (UB4, UB5) is connected with the first input (i1-UB4, i1-UB5) to a series of delays of the respective delay line (LO1) of one of the ring oscillators (GP1) after a delay (EO) having the first number in this series counting from the beginning of the delay line (LO1), and the second input (i2-UB4, i2-UB5) is connected to a series of delays of the respective delay line (LO2) of another ring oscillator (GP2) after a delay (EO) having the second number in this series counting from the beginning of the delay line (LO2), wherein the first number is different from the second number.

5. The random number generator according to claim 1 or 2 or 3 or 4, **characterized in** comprising at least two bistables (UB6, UB7) connected with at least one input each (i1-UB6, i1-UB7; i2-UB6, i2-UB7) in the same place of at least one delay line (LO1; LO3).

## Patentansprüche

1. Ein Zufallszahlengenerator (GL), umfassend eine Vielzahl von bistabilen Kippstufen (UB1, UB2, UB3, UB4, UB5, UB6, UB7), wobei eine erste bistabile Kippstufe (UB1) der Vielzahl von bistabilen Kippstufen einen Ausgang (o-UB1) aufweist, der mit einem ersten Ausgang (o1-GL) des Zufallszahlengenerators (GL) verbunden ist, und umfassend zwei Ringoszillatoren (GP1, GP2), deren Ausgänge (o-GP1, o-GP2) mit Eingängen (i1-UB1, i2-UB1) der ersten bistabilen Kippstufe (UB1) verbunden sind, wobei die Ringoszillatoren Verzögerungsleitungen (LO1, LO2) umfassen, die zu Schleifen geschlossen sind, und wobei die Verzögerungsleitungen (LO1, LO2) Verzögerungsglieder (EO) umfassen, die in Reihe zwischen Eingängen (i-LO1, i-LO2) und Ausgängen (o-LO1, o-LO2) der Verzögerungsleitungen (LO1, LO2) geschaltet sind, wobei der Zufallszahlengenerator (GL) mindestens eine zweite bistabile Kippstufe (UB2, UB3, UB4, UB5, UB6, UB7) der Vielzahl von bistabilen Kippstufen umfasst, wobei jede einen Ausgang (o-UB2, o-UB3, o-UB4, o-UB5, o-UB6, o-UB7) aufweist, der mit einem jeweiligen weiteren Ausgang (o2-GL, o3-GL, o4-GL, o-5GL, o6-GL, o7-GL) des Zufallszahlengenerators (GL) verbunden ist, wobei jede zweite bistabile Kippstufe (UB2, UB3, UB4, UB5, UB6, UB7) einen ersten Eingang (i1-UB2, i1-UB3, i1-UB4, i1-UB5, i1-UB6, i1-UB7) aufweist, der mit der Verzögerungsleitung (LO1) eines der beiden Ringoszillatoren (GP1) verbunden ist, und einen zweiten Eingang (i2-UB2, i2-UB3, i2-UB4, i2-UBS, i2-UB6, i2-UB7), der mit der Verzögerungsleitung (LO2) des anderen der beiden Ringoszillatoren (GP2) verbunden ist, **dadurch gekennzeichnet, dass** zumindest eine der Vielzahl von bistabilen Kippstufen (UB1, UB2, UB3, UB4, UB5, UB6, UB7) ein Phasendetektor (DF) ist, wobei mindestens ein Phasendetektor (DF) ein erstes und ein zweites Flip-Flop (P1), (P2) umfasst, die jeweils zwei Eingänge (D1, C1), (D2, C2) und zwei Ausgänge (Q1, nQ1), (Q2, nQ2) aufweisen, wobei einer der beiden Ausgänge (Q1, nQ1), (Q2, nQ2) ein normaler Ausgang (Q1, Q2) und der andere ein komplementärer Ausgang (nQ1, nQ2) ist;
wobei:
- die Eingänge (D1, C1), (D2, C2) der Flip-Flops (P1), (P2) mit Eingängen (i1-DF, i2-DF) des Phasendetektors (DF) verbunden sind, und wobei
- der erste Eingang des Phasendetektors (i1-DF) sowohl mit dem ersten Eingang (D1) des ersten Flip-Flops (P1) als auch mit dem zweiten Eingang (C2) des zweiten Flip-Flops (P2) verbunden ist,
- der zweite Eingang des Phasendetektors (i2-DF) sowohl mit dem zweiten Eingang (C1) des ersten Flip-Flops (P1) als auch mit dem ersten Eingang (D2) des zweiten Flip-Flops (P2) verbunden ist,
- der Ausgang des Phasendetektors (o-DF) über eine logische Schaltung (AND) sowohl mit dem komplementären Ausgang (nQ1) des ersten Flip-Flops (P1) als auch mit dem normalen Ausgang (Q2) des zweiten Flip-Flops (P2) verbunden ist,
- zumindest eine der Vielzahl von bistabilen Kippstufen (UB1, UB2, UB3, UB4, UB5, UB6, UB7), die kein Phasendetektor ist, eine Metastabilitätsschaltung (UM) ist, die eine metastabile Schaltung mit oszillatorischem Verhalten (UMOO) umfasst, wobei die metastabile Schaltung (UMOO) zwei Eingänge (R, S) aufweist, die die Eingänge der Metastabilitätsschaltung (i1-UM, i2-UM) sind, und einen Ausgang (wOO) aufweist,
- der Ausgang (wOO) der metastabilen Schaltung (UMOO) über einen Addierer (SUM) mit dem Ausgang (o-UM) der Metastabilitätsschaltung (UM) verbunden ist,
- und wobei die Metastabilitätsschaltung (UM) ferner einen Zähler (LCZ) umfasst, dessen Ausgänge mit aufeinanderfolgenden Eingängen des Addierers (SUM) verbunden sind und der einen Eingang (i-LCZ) aufweist, der mit dem Ausgang (wOO) der metastabilen Schaltung (UMMO) verbunden ist.

2. Zufallszahlengenerator nach Patentanspruch 1, **dadurch gekennzeichnet, dass** er mindestens drei Ringoszillatoren (GP1, GP2, GP3) umfasst, und dass die mindestens eine zweite bistabile Kippstufe (UB2, UB3, UB4, UB5, UB6, UB7) den ersten Eingang (i1-UB2, i1-UB3, i1-UB4, i1-UB5, i1-UB6, i1-UB7) aufweist, der mit der Verzögerungsleitung (LO1, LO2) eines der Ringoszillatoren (GP1, GP2) verbunden ist, und den zweiten Eingang (i2-UB2, i2-UB3, i2-UB4, i2-UBS, i2-UB6, i2-UB7), der mit der Verzögerungsleitung (LO2, LO3) des zweiten oder des dritten der Ringoszillatoren (GP2, GP3) verbunden ist.

3. Zufallszahlengenerator nach Patentanspruch 2, **dadurch gekennzeichnet, dass** er mindestens zwei zweite bistabile Kippstufen (UB1, UB2, UB3) umfasst, die mindestens einen der Eingänge (i1-UB2, i1-UB3; i2-UB1, i2-UB2; i1-UB1, i2-UB3) aufweisen, der mit unterschiedlichen Verzögerungsleitungen (LO1, LO2, LO3) unterschiedlicher der drei Ringoszillatoren (GP1, GP2, GP3) verbunden ist.

4. Zufallszahlengenerator nach Patentanspruch 1 oder 2 oder 3, **dadurch gekennzeichnet, dass** mindestens eine der zweiten bistabilen Kippstufen (UB4, UB5) mit dem ersten Eingang (i1-UB4, i1-UB5) mit einer Reihe von Verzögerungsgliedern der jeweiligen Verzögerungsleitung (LO1) eines der Ringoszillatoren (GP1) nach einem Verzögerungsglied (EO) verbunden ist, das in dieser Reihe, vom Anfang der Verzögerungsleitung (LO1) aus gezählt, die erste Nummer aufweist, und der zweite Eingang (i2-UB4, i2-UB5) mit einer Reihe von Verzögerungsgliedern der jeweiligen Verzögerungsleitung (LO2) eines anderen Ringoszillators (GP2) nach einem Verzögerungsglied (EO) verbunden ist, das in dieser Reihe, vom Anfang der Verzögerungsleitung (LO2) aus gezählt, die zweite Nummer aufweist, wobei die erste Nummer sich von der zweiten Nummer unterscheidet.

5. Zufallszahlengenerator nach Patentanspruch 1 oder 2 oder 3 oder 4, **dadurch gekennzeichnet, dass** er mindestens zwei bistabile Kippstufen (UB6, UB7) umfasst, die jeweils mit mindestens einem Eingang (i1-UB6, i1-UB7; i2-UB6, i2-UB7) an derselben Stelle mindestens einer Verzögerungsleitung (LO1; LO3) verbunden sind.

## Revendications

1. Générateur de nombres aléatoires (GL) comprenant une pluralité de bistables (UB1, UB2, UB3, UB4, UB5, UB6, UB7), dans lequel un premier bistable (UB1) de ladite pluralité de bistables possède une sortie (o-UB1) connectée à une première sortie (o1-GL) du générateur de nombres aléatoires (GL), et comprenant deux oscillateurs en anneau (GP1, GP2) ayant des sorties (o-GP1, o-GP2) connectées à des entrées (i1-UB1, i2-UB1) du premier bistable (UB1), dans lequel les oscillateurs en anneau comprennent des lignes à retard (LO1, LO2) fermées en boucles, et les lignes à retard (LO1, LO2) comprennent des retards (EO) connectés en série entre des entrées (i-LO1, i-LO2) et des sorties (o-LO1, o-LO2) des lignes à retard (LO1, LO2), dans lequel le générateur de nombres aléatoires (GL) comprend au moins un deuxième bistable (UB2, UB3, UB4, UB5, UB6, UB7) de ladite pluralité de bistables, chacun ayant une sortie (o-UB2, o-UB3, o-UB4, o-UB5, o-UB6, o-UB7) connectée à une sortie supplémentaire respective (o2-GL, o3-GL, o4-GL, o-5GL, o6-GL, o7-GL) du générateur de nombres aléatoires (GL), dans lequel chaque deuxième bistable (UB2, UB3, UB4, UB5, UB6, UB7) comporte une première entrée (i1-UB2, i1-UB3, i1-UB4, i1-UBS, i1-UB6, i1-UB7) connectée à la ligne à retard (LO1) de l'un des deux oscillateurs en anneau (GP1) et une deuxième entrée (i2-UB2, i2-UB3, i2-UB4, i2-UBS, i2-UB6, i2-UB7) connectée à la ligne à retard (LO2) de l'autre des deux oscillateurs en anneau (GP2), **caractérisé en ce que** l'au moins un desdits bistables (UB1, UB2, UB3, UB4, UB5, UB6, UB7) est un détecteur de phase (DF), dans lequel au moins un détecteur de phase (DF) comprend une première et une deuxième bascule (P1), (P2), chacune ayant deux entrées (D1, C1), (D2, C2) et deux sorties (Q1, nQ1), (Q2, nQ2), dans lequel l'une des deux sorties (Q1, nQ1), (Q2, nQ2) est une sortie normale (Q1, Q2) et l'autre est une sortie complémentaire (nQ1, nQ2) ;
dans lequel :
- les entrées (D1, C1) et (D2, C2) des bascules (P1) et (P2) sont connectées aux entrées (i1-DF, i2-DF) du détecteur de phase (DF), et dans lequel
- la première entrée du détecteur de phase (i1-DF) est connectée à la fois à la première entrée (D1) de la première bascule (P1) et à la deuxième entrée (C2) de la deuxième bascule (P2),
- la deuxième entrée du détecteur de phase (i2-DF) est connectée à la fois à la deuxième entrée (C1) de la première bascule (P1) et à la première entrée (D2) de la deuxième bascule (P2),
- la sortie du détecteur de phase (o-DF) est connectée à la sortie complémentaire (nQ1) de la première bascule (P1) et à la sortie normale (Q2) de la deuxième bascule (P2) par l'intermédiaire d'un circuit logique (ET),
- au moins l'un de ladite pluralité de bistables (UB1, UB2, UB3, UB4, UB5, UB6, UB7), qui n'est pas l'un des au moins un détecteur de phase, est un circuit de métastabilité (UM) qui comprend un circuit métastable à réponse oscillatoire (UMOO), le circuit métastable (UMOO) ayant deux entrées (R, S) qui sont les entrées du circuit de métastabilité (i1-UM, i2-UM) et ayant une sortie (wOO),
- la sortie (wOO) du circuit métastable (UMOO) est connectée à la sortie (o-UM) du circuit de métastabilité (UM) par l'intermédiaire d'un additionneur (SUM),
- le circuit de métastabilité (UM) comprend en outre un compteur (LCZ) dont les sorties sont connectées à des entrées consécutives de l'additionneur (SUM) et dont une entrée (i-LCZ) est connectée à la sortie (wOO) du circuit métastable (UMMO).

2. Générateur de nombres aléatoires selon la revendication 1, **caractérisé en ce qu'**il comprend au moins trois oscillateurs en anneau (GP1, GP2, GP3), et **en ce que** ledit au moins un deuxième bistable (UB2, UB3, UB4, UB5, UB6, UB7) a une première entrée (i1-UB2, i1-UB3, i1-UB4, i1-UB5, i1-UB6, i1-UB7) connectée à la ligne à retard (LO1, LO2) de l'un des oscillateurs en anneau (GP1, GP2) et la deuxième entrée (i2-UB2, i2-UB3, i2-UB4, i2-UBS, i2-UB6, i2-UB7) est connectée à la ligne à retard (LO2, LO3) du deuxième ou du troisième des oscillateurs en anneau (GP2, GP3).

3. Générateur de nombres aléatoires selon la revendication 2, **caractérisé en ce qu'**il comprend au moins deux deuxièmes bistables (UB1, UB2, UB3), dont au moins une des entrées (i1-UB2, i1-UB3 ; i2-UB1, i2-UB2 ; i1-UB1, i2-UB3) est connectée à différentes lignes à retard (LO1, LO2, LO3) de différents oscillateurs en anneau parmi lesdits trois (GP1, GP2, GP3).

4. Générateur de nombres aléatoires selon la revendication 1, 2 ou 3, **caractérisé en ce qu'**au moins l'un des deuxièmes bistables (UB4, UB5) est connecté à la première entrée (i1-UB4, i1-UB5) à une série de retards de la ligne à retard correspondante (LO1) de l'un des oscillateurs en anneau (GP1) après un retard (EO) correspondant au premier numéro de cette série, compté à partir du début de la ligne à retard (LO1), et la deuxième entrée (i2-UB4, i2-UB5) est connectée à une série de retards de la ligne à retard respective (LO2) d'un autre oscillateur en anneau (GP2) après un retard (EO) correspondant au deuxième numéro de cette série en comptant à partir du début de la ligne à retard (LO2), le premier numéro étant différent du deuxième numéro.

5. Générateur de nombres aléatoires selon la revendication 1, 2, 3 ou 4, **caractérisé en ce qu'**il comprend au moins deux bistables (UB6, UB7) connectés à au moins une entrée chacun (i1-UB6, i1-UB7; i2-UB6, i2-UB7) au même endroit qu'au moins une ligne à retard (LO1 ; LO3).
